(19) **Europäisches Patentamt European Patent Office Office européen des brevets**

(11) **EP 4 563 319 A1**

(12) **EUROPEAN PATENT APPLICATION**
published in accordance with Art. 153(4) EPC

(43) Date of publication:
**04.06.2025 Bulletin 2025/23**

(21) Application number: **22952154.7**

(22) Date of filing: **28.07.2022**

(51) International Patent Classification (IPC):
**B29C 45/14** *(2006.01)*

(52) Cooperative Patent Classification (CPC):
**B29C 45/14**

(86) International application number:
**PCT/JP2022/029111**

(87) International publication number:
**WO 2024/024025 (01.02.2024 Gazette 2024/05)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **JTEKT Corporation
Kariya-shi, Aichi 448-8652 (JP)**

(72) Inventors:
• **ADACHI, Tomoya
Kariya-shi, Aichi 448-8652 (JP)**

• **KIMURA, Kouji
Kariya-shi, Aichi 448-8652 (JP)**
• **OISHI, Masaki
Kariya-shi, Aichi 448-8652 (JP)**
• **FUKUMORI, Kohei
Kariya-shi, Aichi 448-8652 (JP)**
• **MORIUCHI, Toshihiro
Kariya-shi, Aichi 448-8652 (JP)**
• **HARAGUCHI, Satoshi
Kariya-shi, Aichi 448-8652 (JP)**

(74) Representative: **Winter, Brandl - Partnerschaft mbB
Alois-Steinecker-Straße 22
85354 Freising (DE)**

(54) **RESIN MOLDED ARTICLE AND METHOD FOR PRODUCING RESIN MOLDED ARTICLE**

(57) A resin molded product has a first molded portion and a second molded portion. The first molded portion has a component as an insert, and a first resin portion that is integral with the component. The second molded portion has a second resin portion. The first resin portion has a first face, a second face, a third face, and a fourth face. The second resin portion is in contact with all faces of the first face, the second face, the third face, and the fourth face, of the first resin portion.

FIG. 5

EP 4 563 319 A1

**Description**

TECHNICAL FIELD

The present disclosure relates to a resin molded product and a manufacturing method of the resin molded product.

BACKGROUND ART

A resin molded product including a connector, for example, is known. A resin molded product disclosed in Patent Document 1 includes a component such as a connector terminal or the like, and a resin housing that is integral with the connector terminal. The housing has a fitting portion for fitting to a mating connector to be connected to the connector terminal. Such resin molded products are manufactured by injection molding, using components such as connector terminals as inserts.

Related Art Documents

Patent Documents

Patent Document 1: Japanese Unexamined Patent Application Publication No. 2022-51061 (JP 2022-51061 A)

SUMMARY OF THE INVENTION

Problem to be Solved by the Invention

In resin molded products such as described above, there are multiple resin molded products which have different shapes of the connector terminals but are identical in other respects, or multiple resin molded products which have different shapes of the fitting portions but are identical in other respects. Multiple molds are required for each resin molded product, for manufacturing thereof. The molds each have a slightly different shape only in part, but the shape is the same for the greater part thereof. In a case in which there are many types of components or fitting portions, such as connector terminals or the like, significant expenditures are required to manufacture and manage a great number of molds.

Accordingly, an object of the present disclosure is to provide a resin molded product that enables reduction in mold-related costs, and to provide a manufacturing method of such a resin molded product.

Means for Solving the Problem

A resin molded product according to the present disclosure includes

a first molded portion and a second molded portion, wherein
the first molded portion has a component as an insert, and a first resin portion that is integral with the component,
the second molded portion has a second resin portion,
the first resin portion has a first face, a second face, a third face, and a fourth face,
the first face is annular,
the second face is a face that includes a normal of the first face,
the second face is annular and extends along the first face,
the second face is disposed adjacent to the first face,
the third face is recessed in a normal direction of the first face,
the third face is annular and extends along the first face,
the third face is disposed adjacent to the first face, on an opposite side from the second face, the fourth face is recessed in a normal direction of the second face,
the fourth face is annular and extends along the second face,
the fourth face is disposed adjacent to the second face, on an opposite side from the first face, a distance on the first face between the second face and the third face in the normal direction of the second face is defined as a first distance,
a distance on the second face between the first face and the fourth face in the normal direction of the first face is defined as a second distance,
a distance on the third face between the first face and a position on the third face farthest from the first face in the normal direction of the first face is defined as a third distance,
a distance on the fourth face between the second face and a position on the fourth face farthest from the second face in the normal direction of the second face is defined as a fourth distance, the fourth distance has a relation as to the first distance of $1/3 \leq$ the fourth distance / the first distance $\leq 9/10$,

the third distance has a relation as to the second distance of $1/3 \leq$ the third distance / the second distance $\leq 9/10$,

the first distance has a relation as to the second distance of $2/5 \leq$ the first distance / the second distance $\leq 5/2$, and

the second resin portion is in contact with all faces of the first face, the second face, the third face, and the fourth face, of the first resin portion.

A manufacturing method of a resin molded product according to the present disclosure is a manufacturing method of the above resin molded product, the manufacturing method including

a preparation process of placing the first molded portion in a mold,

a molding process of supplying molten resin to the mold and molding the second molded portion, and

a demolding process of removing, from the mold, the resin molded product in which the first molded portion and the second molded portion have become integral when the molten resin is solidified.

Effects of the Invention

According to the resin molded product and the manufacturing method thereof according to the present disclosure, even when there are many types of resin molded products, significant expenditures related to manufacturing and managing a great number of molds can be suppressed. According to the resin molded product of the present disclosure, sealing properties between the first resin portion and the second resin portion are good, and moisture is less likely to intrude into gaps between the first resin portion and the second resin portion from external space.

BRIEF DESCRIPTION OF THE DRAWINGS

[FIG. 1] FIG. 1 is a perspective view illustrating an example of a resin molded product.
[FIG. 2] FIG. 2 is an explanatory diagram of a manufacturing method of the resin molded product.
[FIG. 3] FIG. 3 is an explanatory diagram of a preparation process for secondary injection molding.
[FIG. 4] FIG. 4 is an explanatory diagram of a molding process for secondary injection molding.
[FIG. 5] FIG. 5 is a cross-sectional view of part of the resin molded product.
[FIG. 6] FIG. 6 is an explanatory diagram of the resin molded product after secondary injection molding is ended.
[FIG. 7] FIG. 7 is a perspective view of a first molded portion.
[FIG. 8] FIG. 8 is an enlarged cross-sectional view of part of FIG. 5.

MODES FOR CARRYING OUT THE INVENTION

<Overview of Embodiments of the Invention of the Present Disclosure>

Hereinafter, an overview of the embodiments of the invention of the present disclosure will be listed and described.

(1A) A resin molded product according to the present disclosure includes a first molded portion and a second molded portion, wherein

the first molded portion has a component as an insert, and a first resin portion that is integral with the component,
the second molded portion has a second resin portion,
the first resin portion has a first face, a second face, a third face, and a fourth face,
the first face is annular,
the second face is a face that includes a normal of the first face,
the second face is annular and extends along the first face,
the second face is disposed adjacent to the first face,
the third face is recessed in a normal direction of the first face,
the third face is annular and extends along the first face,
the third face is disposed adjacent to the first face, on an opposite side from the second face, the fourth face is recessed in a normal direction of the second face,
the fourth face is annular and extends along the second face,

the fourth face is disposed adjacent to the second face, on an opposite side from the first face, a distance on the first face between the second face and the third face in the normal direction of the second face is defined as a first distance,

a distance on the second face between the first face and the fourth face in the normal direction of the first face is defined as a second distance,

a distance on the third face between the first face and a position on the third face farthest from the first face in the normal direction of the first face is defined as a third distance,

a distance on the fourth face between the second face and a position on the fourth face farthest from the second face in the normal direction of the second face is defined as a fourth distance, the fourth distance has a relation as to the first distance of $1/3 \leq$ the fourth distance / the first distance $\leq 9/10$,

the third distance has a relation as to the second distance of $1/3 \leq$ the third distance / the second distance $\leq 9/10$,

the first distance has a relation as to the second distance of $2/5 \leq$ the first distance / the second distance $\leq 5/2$, and the second resin portion is in contact with all faces of the first face, the second face, the third face, and the fourth face, of the first resin portion.

According to the resin molded product of the present disclosure, even when there are many types of resin molded products, significant expenditures related to manufacturing and managing a great number of molds can be suppressed. According to the resin molded product of the present disclosure, sealing properties between the first resin portion and the second resin portion are good, and moisture is less likely to intrude into gaps between the first resin portion and the second resin portion from external space.

When the second molded portion is molded by injection molding using the first molded portion as an insert, joint strength between the first molded portion and the second molded portion, and sealing properties between the two, are issues. Intrusion of moisture in the air causes deterioration such as corrosion and so forth of the first resin portion, the second resin portion, and the insert.

The resin molded product of the present disclosure can solve these issues.

(2A) A manufacturing method of the resin molded product according to the present disclosure is a manufacturing method of the resin molded product according to the above (1A), the manufacturing method including

a preparation process of placing the first molded portion in a mold,
a molding process of supplying molten resin to the mold and molding the second molded portion, and
a demolding process of removing, from the mold, the resin molded product in which the first molded portion and the second molded portion have become integral when the molten resin is solidified.

According to the manufacturing method of the resin molded product according to the present disclosure, in cases in which the shape of the component that the first molded portion has or the shape of part of the first resin portion surrounding the component varies, changing the mold for molding the first molded portion is all that has to be done. The mold for molding the second molded portion can be used in common. Accordingly, mold-related costs can be reduced. Strength between the first resin portion and the second resin portion, and the sealing properties therebetween, can be increased.

(1B) A resin molded product according to another aspect of the present disclosure includes

a first molded portion that has a component as an insert, and a first resin portion that is integral with the component, and a second molded portion that is integral with the first molded portion as an insert, wherein the second molded portion has a second resin portion covering at least a peripheral edge portion of the first resin portion,
a joint interface between the first resin portion and the second resin portion includes
a first interface,
a second interface that is annular and that has a face that is continuous with an entire peripheral edge of the first interface and intersects with the first interface,
a first recessed interface that is recessed from the first interface, and
a second recessed interface that is recessed from the second interface, in which
the first recessed interface is formed annularly, extending along an edge region of the first interface, and
the second recessed interface is formed annularly, extending along the second interface within a range overlapping with the edge region.

According to the resin molded product, in cases in which the shape of the component that the first molded portion has or the shape of part of the first resin portion surrounding the component varies, changing the mold for molding the first molded portion is all that has to be done. The mold for molding the second molded portion can be used in common. Accordingly, mold-related costs can be reduced as compared to conventional arrangements.

When the second molded portion is molded by injection molding using the first molded portion as an insert, joint strength between the first molded portion and the second molded portion, and sealing properties between the two, are issues.

Accordingly, in the resin molded product according to the present disclosure, the first recessed interface and the second recessed interface are recessed in different directions. The first recessed interface is located in an edge region of the first interface, and the second recessed interface is located within a range overlapping the edge region, and accordingly the first recessed interface and the second recessed interface are near to each other. The resin of the second resin portion enters into and comes into contact with the first recessed interface and the second recessed interface such as described above. Accordingly, due to the contraction during molding of the second resin portion, strength of the joint portion between the first resin portion and the second resin portion, and airtightness therebetween, can be increased.

(2B) Preferably, the first interface has a first face that is planar, the second interface has a second face that is planar and that is orthogonal to the first face, the first recessed interface has a third face that is located on an opposite side from the second face and is orthogonal to the first face, and the second recessed interface has a fourth face that is located on an opposite side from the first face and is orthogonal to the second face. According to this configuration, the first face and the second face are orthogonal to each other. The third face is a face orthogonal to the first face, and the fourth face is a face orthogonal to the second face. When the first molded portion is manufactured by injection molding, forcible removal from the mold tends not to be required, and the mold has high removal performance.

(3B) Preferably, in a case in which a distance extending along the first face between the second face and the third face is defined as a first distance, a distance extending along the second face between the first face and the fourth face is defined as a second distance, a distance extending along the third face between the first face and a position of the third face that is farthest from the first face is defined as a third distance, and a distance extending along the fourth face between the second face and a position of the fourth face that is farthest from the second face is defined as a fourth distance, the relation expressions

$$1/3 \times \text{ the first distance} \leq \text{ the fourth distance} \leq 9/10 \times \text{ the first distance}$$

$$1/3 \times \text{ the second distance} \leq \text{ the third distance} \leq 9/10 \times \text{ the second distance}$$

$$0.4 \leq \text{ the first distance / the second distance} \leq 2.5 \text{ are satisfied.}$$

According to this configuration, the strength of the joint portion between the first molded portion and the second molded portion can be further improved. In the first molded portion, decrease in strength of the resin portion including the edge region of the first interface can be suppressed. This enables securing of strength of the joint portion with respect to contraction during molding of the second resin portion to be more reliable.

(4B) A manufacturing method of a resin molded product of the present disclosure according to another aspect is a manufacturing method of the resin molded product according to any one of the above (1B) to (3B), the manufacturing method including

a preparation process of placing the first molded portion in a mold,
a molding process of supplying molten resin to the mold and molding the second molded portion, and
a demolding process of removing, from the mold, the resin molded product in which the first molded portion and the second molded portion have become integral when the molten resin is solidified.

According to the manufacturing method of the resin molded product according to the present disclosure, in cases in which the shape of the component that the first molded portion has or the shape of part of the first resin portion surrounding the component varies, changing the mold for molding the first molded portion is all that has to be done. The mold for molding the second molded portion can be used in common. Accordingly, mold-related costs can be reduced. Strength of the joint portion between the first resin portion and the second resin portion and airtightness therebetween can be increased.

<Details of Embodiments of the Invention of the Present Disclosure>

Embodiments of the invention according to the present disclosure will be described below.

[Resin Molded Product and Manufacturing Method Thereof]

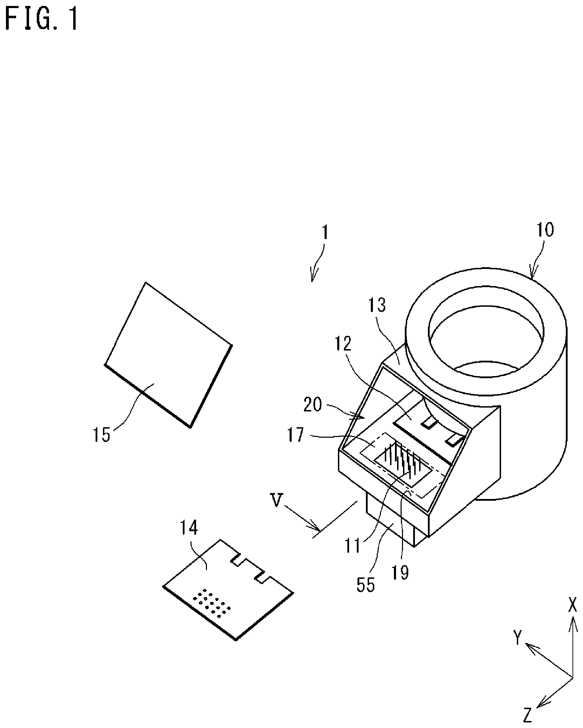

FIG. 1 is a perspective view illustrating an example of a product. A product 1 illustrated in FIG. 1 includes a resin molded product 10, a substrate 14, and a lid 15. The resin molded product 10 includes a connector terminal 11 as a first component, a sensor 12 as a second component, and a housing 13. The connector terminal 11, the sensor 12, and the housing 13 are not separated. The substrate 14 is mounted to the housing 13. The lid 15 is fixed to the housing 13. FIG. 1 illustrates the product 1, in which the substrate 14, the lid 15, and the resin molded product 10 are separated. The product 1 is a sensor device.

The housing 13 is made of resin. The resin molded product 10 is a composite component in which the housing 13, the connector terminal 11, and the sensor 12 are integrally molded by injection molding. The resin molded product 10 can be sectioned into a first molded portion 16 and a second molded portion 18.

Injection molding includes primary injection molding and secondary injection molding.

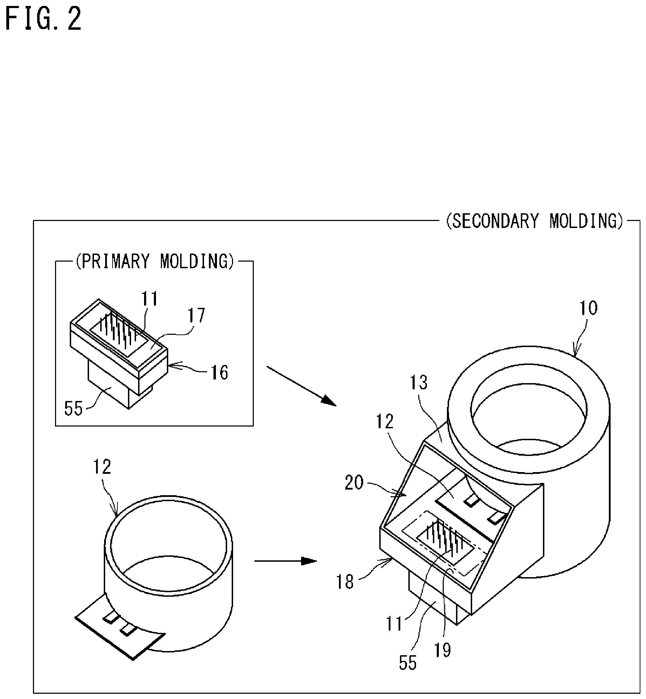

FIG. 2 is an explanatory diagram of a manufacturing method of the resin molded product 10. The primary injection molding is injection molding in which a first resin portion 17 is integrally molded, with the connector terminal 11 as an insert. The first molded portion 16 is a part including a connector terminal 11 (component), and a first resin portion 17. The connector terminal 11 (component) and the first resin portion 17 are integral with each other.

Secondary injection molding is injection molding in which a second resin portion 19 is molded using the first molded portion 16 and the sensor 12 as inserts. The second molded portion 18 is a part that includes the sensor 12 and the second resin portion 19.

The resin molded product 10 is manufactured by secondary injection molding. The resin molded product 10 is a composite component in which the first molded portion 16 and the second molded portion 18 are integrated together.

The housing 13 includes the first resin portion 17 and the second resin portion 19. The housing has a fitting portion 55 in the first resin portion 17. The connector terminal 11 is fixed to the fitting portion 55 of the housing 13.

A mating connector that is omitted from illustration fits to the fitting portion 55. The mating connector is a separate item from the resin molded product 10. When the fitting portion 55 and the mating connector are connected, the connector terminal 11 is connected to a mating connector terminal that has the mating connector.

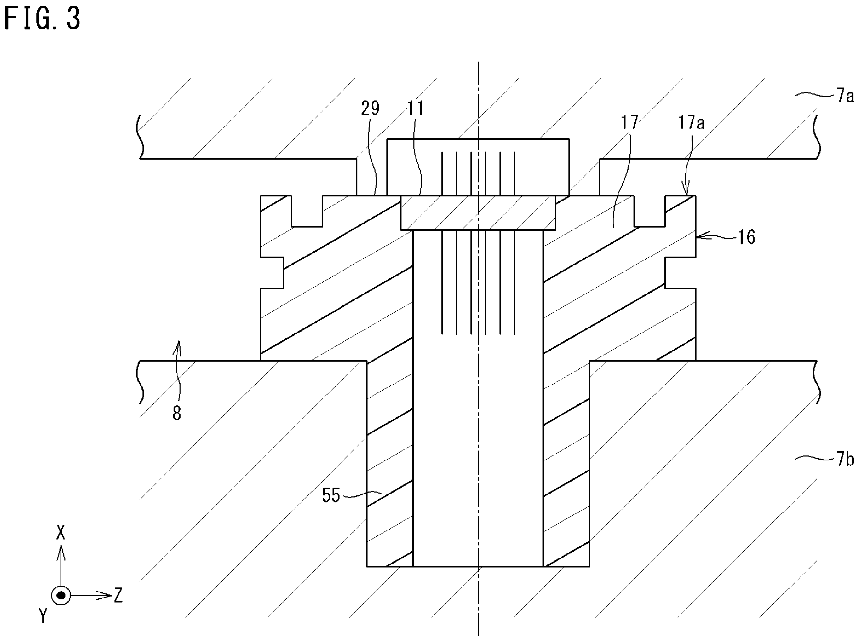

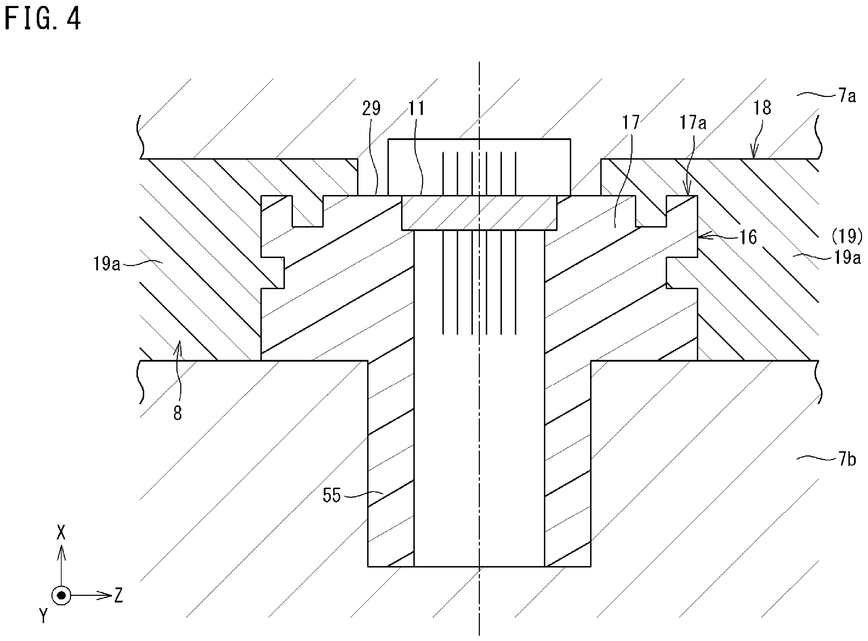

FIGS. 3 and 4 are explanatory diagrams of secondary injection molding. FIG. 3 illustrates a preparation process in which the first molded portion 16 is placed in molds 7a and 7b. The first molded portion 16 and the sensor 12 that is omitted from illustration in FIG. 3 are disposed at predetermined positions in the molds 7a and 7b.

FIG. 4 illustrates a molding process in which the first molded portion 16 and the sensor 12 are placed as inserts in a cavity 8 of the molds 7a and 7b, and then molten resin 19a is supplied to integrally mold the second resin portion 19. The secondary injection molding is injection molding in which molten resin 19a that is supplied into the cavity 8 is solidified. The first molded portion 16 and the second molded portion 18 are integrated together by the molten resin 19a solidifying.

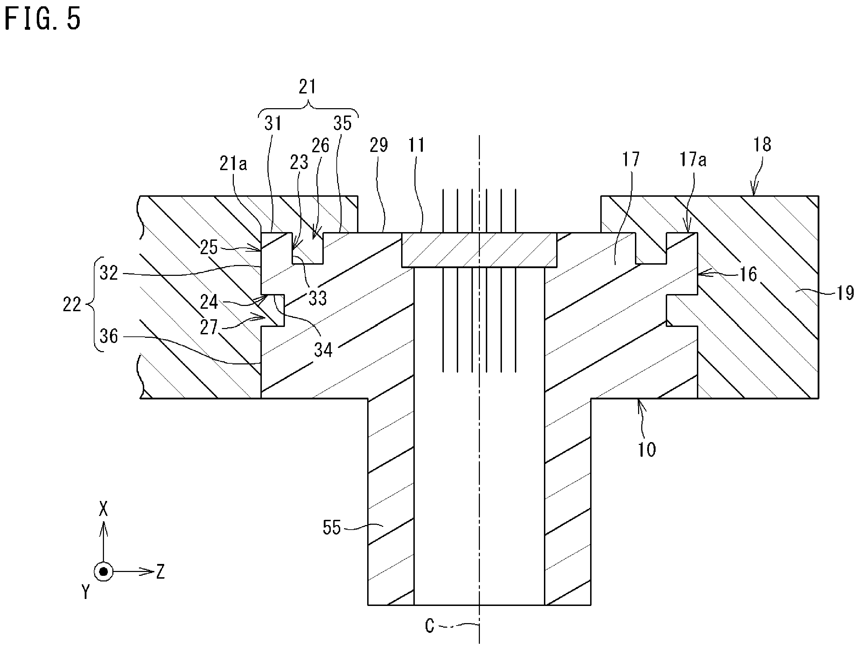

FIG. 5 is a cross-sectional view of a part of the resin molded product 10 obtained after being removed from the molds 7a and 7b. FIG. 5 is a cross-sectional view as viewed from a direction of arrow V in FIG. 1, and is a cross-sectional view taken along a plane including a center reference line C of the first molded portion 16.

The resin molded product 10, in which the first molded portion 16 and the second molded portion 18 are integrated, is removed from the molds 7a and 7b. The process of removing the resin molded product 10, in which the first molded portion 16 and the second molded portion 18 are integrated, from the molds 7a, 7b, is a removal process. A solidified part of the molten resin 19a is the second resin portion 19. The second resin portion 19 covers part of the first resin portion 17.

As illustrated in FIG. 1, the resin molded product 10 manufactured by secondary injection molding has an accommodation space 20. The substrate 14 is mounted in the accommodation space 20. The substrate 14 is electrically connected to the connector terminal 11. The substrate 14 is electrically connected to the sensor 12. The lid 15 closes the accommodation space 20. The lid 15, which is made of resin, is fixed to the resin molded product 10 by, for example, laser welding. The accommodation space 20 is a closed space. The process of mounting the substrate 14 to the resin molded product 10, and fixing the lid 15 to the resin molded product 10, is an assembly process.

As described above, the preparation process (see FIG. 3), the molding process (see FIG. 4), the removal process (see FIG. 5), and the assembly process (see FIG. 1), are carried out in this order. The preparation process (see FIG. 3) is a process of placing the first molded portion 16 manufactured by the primary injection molding in the molds 7a and 7b. The molding process is a process of supplying the molten resin 19a to molds 7a and 7b, and solidifying the molten resin 19a to mold the second molded portion 18. The removal process is a process of removing the resin molded product 10, in which the first molded portion 16 and the second molded portion 18 are integrated, from the molds 7a and 7b. The assembly process is a process of assembling the substrate 14 and the lid 15 to the resin molded product 10. The product 1 is completed through these four processes.

As illustrated in FIG. 1, part of the connector terminal 11 is exposed from the housing 13 within the accommodation space 20 in a rectangular range. An X direction is a direction that is perpendicular to a plane containing the rectangle. A Y direction is a direction that is orthogonal to the X direction and that extends along the long side of the rectangle. A Z direction is a direction that is orthogonal to the X direction and the Y direction and that extends along the short side of the rectangle. Each of the drawings shows the X direction, the Y direction, and the Z direction, respectively.

In each drawing, an arrowhead side of an X-direction arrow is a first side in the X-direction, and an opposite side to the arrowhead is a second side in the X-direction. In each drawing, an arrowhead side of a Y-direction arrow is a first side in the Y-direction, and an opposite side to the arrowhead is a second side in the Y-direction. In each drawing, an arrowhead side of a Z-direction arrow is a first side in the Z-direction, and an opposite side the arrowhead is a second side in the Z-direction.

In the form illustrated in FIGS. 1 and 2, the first molded portion 16 of the resin molded product 10 includes the connector terminal 11 as a first component, and the second molded portion 18 includes the sensor 12 as a second component, but the second component may be omitted. The first component may be a component other than the connector terminal 11. In a case in which the second component is included in the resin molded product 10, the second component may be other than the sensor 12.

[Regarding First Molded Portion 16 and Second Molded Portion 18]

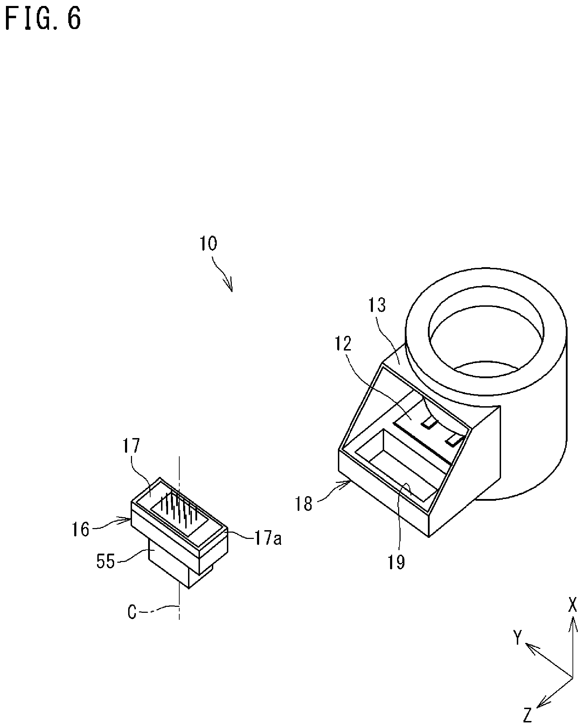

As described with reference to FIG. 2, the first molded portion 16 is manufactured by primary injection molding. The first molded portion 16 has the connector terminal 11 as an insert, and the first resin portion 17 that is integral with the connector terminal 11. The second molded portion 18 is manufactured by secondary injection molding. The second molded portion 18 has the second resin portion 19 that is integral with the first molded portion 16 serving as an insert. FIG. 6 is an explanatory diagram of the resin molded product 10 after secondary injection molding is ended. FIG. 6 is a conceptual diagram in which the first molded portion 16 is separated from the second molded portion 18 in order to distinguish and describe the first molded portion 16.

As described above (see FIG. 4), the molten resin 19a molded in the secondary injection molding becomes the second resin portion 19 of the second molded portion 18 by solidifying. The second resin portion 19 covers part of the first resin portion 17. As illustrated in FIG. 6, the second resin portion 19 has an annular part. The annular part covers the first resin portion 17 annularly. The second resin portion 19 covers at least part of the first resin portion 17 annularly.

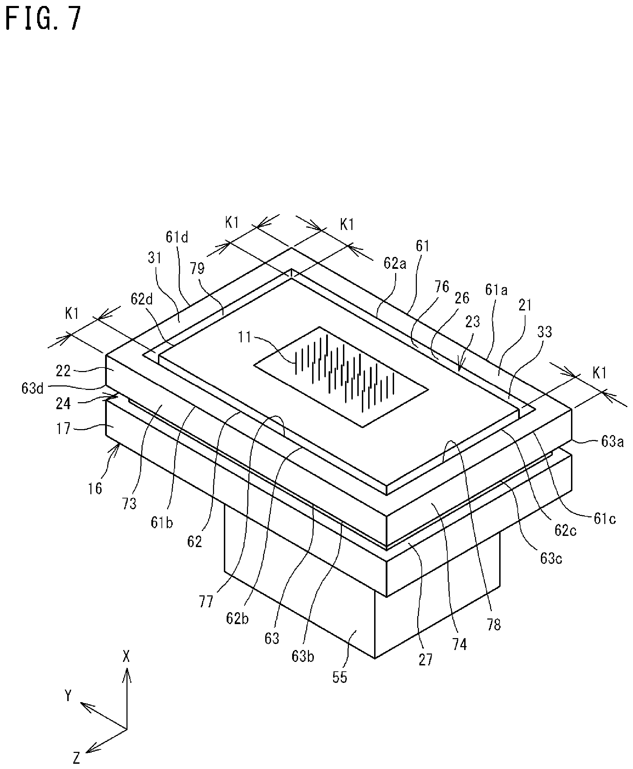

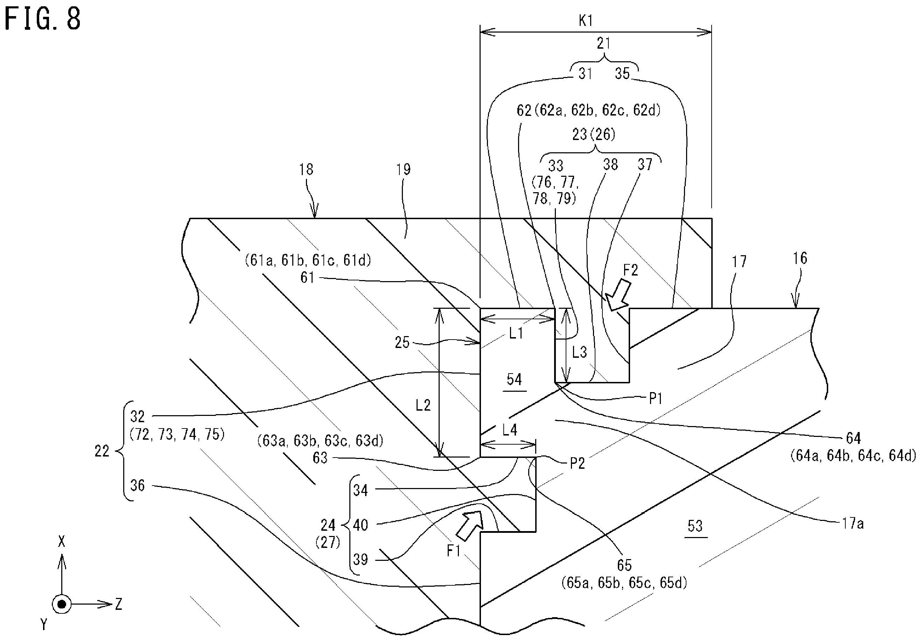

As illustrated in FIG. 7, the first resin portion 17 includes a first groove 26 and a second groove 27. The first groove 26 is an annular groove recessed in the X direction from a plane perpendicular to the X direction. The second groove 27 is an annular groove having groove portions recessed from two planes, each of which the perpendicular direction is the Y direction, and groove portions recessed from two planes, each of which the perpendicular direction is the Z direction. As illustrated in FIG. 8, the second resin portion 19 completely fills the first groove 26 and the second groove 27. The second resin portion 19 is in contact with each face that makes up the first groove 26 and each face that makes up the second groove 27.

The first resin portion 17 has a first face 31, a second face 32, a third face 33, and a fourth face 34. The third face 33 is a face that is adjacent to the first face 31 of the first groove 26. The fourth face 34 is a face of the second groove 27 that is adjacent to the second face 32. The first resin portion 17 further includes a fifth face 35, a sixth face 36, a seventh face 37, an eighth face 38, a ninth face 39, and a tenth face 40.

The fifth face 35 is a face on an opposite side from the first face 31 across the first groove 26. The fifth face 35 and the first face 31 are on the same plane. Each face of the sixth face 36 is a face on an opposite side from each face of the second face 32 across the second groove 27. Each face of the sixth face 36 and each face of the second face 32 are each on the same plane. The seventh face 37 of the first groove 26 is a face that is adjacent to the fifth face 35. The eighth face 38 is a face between the third face 33 and the fifth face 35. Each face of the ninth face 39 is a face of the second groove 27 that is adjacent to each face of the sixth face 36, respectively. Each face of the tenth face 40 is a face between each face of the fourth face 34 and each face of the ninth face 39.

The first face 31 is a first plane that is perpendicular to the X-axis and is annular. The first face 31 is parallel to the Y axis and is parallel to the Z axis. The first face 31 is an annular face between a first perimeter 61 and a second perimeter 62. The first perimeter 61 has a first long side 61a, a second long side 61b, a first short side 61c, and a second short side 61d, of a rectangle. The second perimeter 62 has a third long side 62a, a fourth long side 62b, a third short side 62c, and a fourth short side 62d, of a rectangle. The third long side 62a and the fourth long side 62b are located between the first long side 61a and the second long side 61b. The first long side 61a, the second long side 61b, the third long side 62a, and the fourth long side 62b are on the same plane and are parallel to each other. The third short side 62c and the fourth short side 62d are located between the first short side 61c and the second short side 61d. The first short side 61c, the second short side 61d, the third short side 62c, and the fourth short side 62d are on the same plane and are parallel to each other.

The second face 32 is a face having a perpendicular line in a direction perpendicular to the X-axis. The second face 32 is a face that includes the normal to the first face 31. The second face 32 is an annular face that extends along the first face 31.

The second face 32 is an annular face between the first perimeter 61 and a third perimeter 63. The third perimeter 63 matches a perimeter obtained by moving the first perimeter 61 to the second side in the X direction. The third perimeter 63 includes a fifth long side 63a, a sixth long side 63b, a fifth short side 63c, and a sixth short side 63d, of a rectangle. The fifth long side 63a is located on the second side in the X direction of the first long side 61a. The sixth long side 63b is located on the second side in the X direction of the second long side 61b. The fifth short side 63c is located on the second side in the X direction of the first short side 61c. The sixth short side 63d is located on the second side in the X direction of the second short side 61d. A second plane 72 is between the first long side 61a and the fifth long side 63a. A third plane 73 is between the second long side 61b and the sixth long side 63b. A fourth plane 74 is between the first short side 61c and the fifth short side 63c. A fifth plane 75 is between the second short side 61d and the sixth short side 63d. The second face 32 has the second plane 72, the third plane 73, the fourth plane 74, and the fifth plane 75.

The third face 33 is a face on an opposite side from the second face 32 with respect to the first face 31. The third face 33 is recessed in a normal direction of the first face 31. The third face 33 is a side face of the first groove 26. The third face 33 is an annular face that extends along the first face 31. The third face 33 is an annular face between the second perimeter 62 and the fourth perimeter 64. The fourth perimeter 64 matches a perimeter obtained by moving the second perimeter 62 to the second side in the X direction. The fourth perimeter 64 includes a seventh long side 64a, an eighth long side 64b, a seventh short side 64c, and an eighth short side 64d, of a rectangle. The seventh long side 64a is located on the second side in the X direction of the third long side 62a. The eighth long side 64b is located on the second side in the X direction of the fourth long side 62b. The seventh short side 64c is located on the second side in the X direction of the third short side 62c. The eighth short side 64d is located on the second side in the X direction of the fourth short side 62d. A sixth plane 76 is between the third long side 62a and the seventh long side 64a. A seventh plane 77 is between the fourth long side 62b and the eighth long side 64b. An eighth plane 78 is between the third short side 62c and the seventh short side 64c. A ninth plane 79 is between the fourth short side 62d and the eighth short side 64d. The third face 33 has the sixth plane 76, the seventh plane 77, the eighth plane 78, and the ninth plane 79.

The fourth face 34 is on the opposite side from the first face 31 with respect to the second face 32. The fourth face 34 is recessed in a normal direction of the second face. The fourth face 34 is a side face of the second groove 27. The fourth face 34 is a tenth plane 80 that is annular and that extends along the second face 32. The fourth face 34 is an annular face between the third perimeter 63 and the fifth perimeter 65. The fifth perimeter 65 includes a ninth long side 65a, a tenth long side 65b, a ninth short side 65c, and a tenth short side 65d, of a rectangle. The ninth long side 65a is located on the first side in the Z direction of the fifth long side 63a. The tenth long side 65b is located on the second side in the Z direction of the sixth long side 63b. The ninth short side 65c is located on the first side in the Y direction of the fifth short side 63c. The tenth short side 65d is located on the second side in the Y direction of the sixth short side 63d. The ninth long side 65a and the tenth long side 65b are located between the fifth long side 63a and the sixth long side 63b. The fifth long side 63a, the sixth long side 63b, the ninth long side 65a and the tenth long side 65b are on the same plane and are parallel to each other. The ninth short side 65c and the tenth short side 65d are located between the fifth short side 63c and the sixth short side 63d. The fifth short side 63c, the sixth short side 63d, the third short side 65c and the fourth short side 65d are on the same plane and are parallel to each other.

A first distance L1 is a distance on the first face 31 in the normal direction of the second face 32 at any point on the first perimeter 61, and is a distance between the second face 32 and the third face 33. The first distance L1 is a distance on the first plane 31 in the normal direction of the second plane 72 at any point on the first long side 61a, and includes the distance between the first long side 61a and the third long side 62a. The first distance L1 is a distance on the first plane 31 in the normal direction of the third plane 73 at any point on the second long side 61b, and includes the distance between the second long side 61b and the fourth long side 62b. The first distance L1 is a distance on the first plane 31 in the normal direction of the fourth plane 74 at any point on the first short side 61c, and includes the distance between the first short side 61c and the third short side 62c. The first distance L1 is a distance on the first plane 31 in the normal direction of the fifth plane 75 at any point on the second short side 61d, and includes the distance between the second short side 61d and the fourth short side 62d.

A second distance L2 is a distance on the second face 32 in the normal direction of the first face 31 at any point on the first perimeter 61, and is the distance between the first face 31 and the fourth face 34. The second distance L2 is a distance on the second plane 72 in the normal direction of the first plane 31 at any point on the first long side 61a, and includes the distance between the first long side 61a and the fifth long side 63a. The second distance L2 is a distance on the third plane 73 in the normal direction of the first plane 31 at any point on the second long side 61b, and includes the distance between the second long side 61b and the sixth long side 63b. The second distance L2 is a distance on the fourth plane 74 in the normal direction of the first plane 31 at any point on the first short side 61c, and includes the distance between the first short side 61c and the fifth short side 63c. The second distance L2 is a distance on the fifth plane 75 in the normal direction of the first plane 31 at any point on the second short side 61d, and includes the distance between the second short side 61d and the sixth short side 63d.

A third distance L3 is a distance on the third face 33 in the normal direction of the first face 31 at any point on the second perimeter 62, and is a distance between the first face 31 and a position farthest from the first face 31. The third distance L3 is a distance on the sixth plane 76 in the normal direction of the first plane 31 at any point on the third long side 62a, and includes the distance between the third long side 62a and the seventh long side 64a. The third distance L3 is a distance on the seventh plane 77 in the normal direction of the first plane 31 at any point on the fourth long side 62b, and includes the distance between the fourth long side 62b and the eighth long side 64b. The third distance L3 is a distance on the eighth plane 78 in the normal direction of the first plane 31 at any point on the third short side 62c, and includes the distance between the third short side 62c and the seventh short side 64c. The third distance L3 is a distance on the ninth plane 79 in the normal direction of the first plane 31 at any point on the fourth short side 62d, and includes the distance between the fourth short side 62d and the eighth short side 64d.

The fourth distance L4 is a distance on the fourth face 34 in the normal direction of the second face 32 at any point on the third perimeter 63, and is the distance between the second face 32 and a position farthest from the second face 32. The fourth distance L4 is a distance on the tenth plane 80 in the normal direction of the second plane 72 at any point on the fifth long side 63a, and includes the distance between the fifth long side 63a and the ninth long side 65a. The fourth distance L4 is a distance on the tenth plane 80 in the normal direction of the third plane 73 at any point on the sixth long side 63b, and includes the distance between the sixth long side 63b and the tenth long side 65b. The fourth distance L4 is a distance on the tenth plane 80 in the normal direction of the fourth plane 74 at any point on the fifth short side 63c, and includes the distance between the fifth short side 63c and the ninth short side 65c. The fourth distance L4 is a distance on the tenth plane 80 in the normal direction of the fifth plane 75 at any point on the fifth short side 63d, and includes the distance between the sixth short side 63d and the tenth short side 65d.

After the secondary injection molding, the second resin portion 19 is in contact with all faces of the first face 31, the second face 32, the third face 33, and the fourth face 34, of the first resin portion 17. After the secondary injection molding, each face of the first face 31, the second face 32, the third face 33, and the fourth face 34, of the first resin portion 17 forms an interface with the second resin portion 19. After the secondary injection molding, the second resin portion 19 is in contact with all faces of the first groove 26 and the second groove 27 of the first resin portion 17. The first face 31 and the second face 32 are connected at a corner portion. The locus of this corner portion is the first perimeter 61. The first face 31 and the third face 33 are connected at a corner portion. The locus of this corner portion is the second perimeter 62. The second face 32 and the fourth face 34 are connected at a corner portion. The locus of this corner portion is the third perimeter 63.

[Regarding Resin Molded Product 10]

The second molded portion 18 is injection-molded using the first molded portion 16 as an insert (insert product), and accordingly a joint interface 25 is obtained between the first resin portion 17 and the second resin portion 19 (see FIG. 5). The first resin portion 17 has, as the joint interface 25 with the second resin portion 19, a first interface 21, a second interface 22, a first recessed interface 23, and a second recessed interface 24. The second resin portion 19 covers the entirety of the first interface 21 and also covers the entirety of the second interface 22. The second resin portion 19 covers the entirety of the first recessed interface 23 and also covers the entirety of the second recessed interface 24.

In the case of the form illustrated in FIG. 5, the first interface 21 is part of an upper-side face 29 of the first molded portion 16 that faces the X direction. The second resin portion 19 has an annular part that covers a peripheral edge portion 17a of the first resin portion 17 (see FIG. 5 and FIG. 6). The first interface 21 is an annular face centered on the center reference line C in the X direction. The first interface 21 has the first face 31 that is planar. Further, the first interface 21 has the fifth face 35 on the opposite side to the first face 31 with the first recessed interface 23 interposed therebetween.

The second interface 22 is a side face facing the Y direction, a direction opposite to the Y direction, the Z direction, and a direction opposite to the Z direction. That is to say, the second interface 22 is an annular (tubular) face. The second interface 22 has the second face 32. The second face 32 is continuous from an entire peripheral edge 21a of the first interface 21 and intersects the first interface 21. In this embodiment, the second face 32 is a plane orthogonal to the first face 31. Further, the second interface 22 has the sixth face 36 on the opposite side to the second face 32 with the second recessed interface 24 interposed therebetween.

The second interface 22 has four second faces 32 that are planar, as faces that face in the Y direction, the direction opposite to the Y direction, the Z direction, and the direction opposite to the Z direction, respectively. The second faces 32 are faces that extend in a direction orthogonal to the first face 31 (first interface 21). The second interface 22 has four sixth faces 36 that are planar, as faces that face in same directions as the second faces 32.

FIG. 7 is a perspective view of the first molded portion 16. The first recessed interface 23 is a face recessed from the first interface 21. The first recessed interface 23 extends continuously along the first interface 21 which is annular. The first recessed interface 23 is the first groove 26 that is annular, in a case in which the first molded portion 16 is viewed alone. FIG. 8 is an enlarged cross-sectional view of part of FIG. 5 The first recessed interface 23 has the third face 33, a first opposing face (seventh face 37), and a first bottom face (eighth face 38). The third face 33 is located on the opposite side from the second face 32 and is orthogonal to the first face 31. The first opposing face (seventh face 37) is a face that opposes the third face 33. The first bottom face (eighth face 38) is the bottom face of the first groove 26 and connects the third face 33 and the first opposing face (seventh face 37).

As illustrated in FIG. 7, the second recessed interface 24 is a face recessed from the second interface 22. The second recessed interface 24 extends continuously along the second interface 22 which is annular. The second recessed interface 24 is the second groove 27 that is annular, in a case in which the first molded portion 16 is viewed alone. As illustrated in FIG. 8, the second recessed interface 24 has the fourth face 34, a second opposing face (ninth face 39), and a second bottom face (tenth face 40). The fourth face 34 is located on the opposite side from the first face 31 and is orthogonal to the second face 32. The second opposing face (ninth face 39) is a face opposing the fourth face 34. The second bottom face (tenth face 40) is the bottom face of the second groove 27 and connects the fourth face 34 and the second opposing face (ninth face 39).

As illustrated in FIG. 7 and FIG. 8, in the first resin portion 17, the first recessed interface 23 and the second recessed interface 24 are disposed close to each other. The first recessed interface 23 is formed in an annular shape extending along an edge region K1 of the first interface 21. The second recessed interface 24 is formed in an annular shape extending along the second interface 22 within a range overlapping with the edge region K1. The second recessed interface 24 is formed within a range overlapping with the edge region K1 of the first interface 21 in the Z direction, the direction opposite to the Z direction, the Y direction, and the direction opposite to the Y direction.

[Regarding Resin Molded Product 10 Having Above Configuration]

As described above, the resin molded product 10 according to the present embodiment (see FIG. 5) includes the first molded portion 16 and the second molded portion 18. The first molded portion 16 has the connector terminal 11 as an insert, and the first resin portion 17 that is integral with the connector terminal 11. The second molded portion 18 has the second resin portion 19. The first resin portion 17 has the first face 31, the second face 32, the third face 33, and the fourth face 34. The second resin portion 19 is in contact with all faces of the first face 31, the second face 32, the third face 33, and the fourth face 34, of the first resin portion 17.

According to the resin molded product 10 of the present embodiment, even in cases in which the shape of the connector terminal 11 that the first molded portion 16 has or the fitting portion 55 of the first resin portion 17 varies, changing the mold for molding the first molded portion 16 is all that has to be done. On the other hand, the molds 7a and 7b (see FIG. 3 and FIG. 4) for molding the second molded portion 18 can be used in common. This enables mold-related costs to be reduced as compared to the conventional method, which requires multiple molds that are the same shape for the greater part with only slight differences in shape.

When the second molded portion 18 is molded by injection molding using the first molded portion 16 as an insert, joint strength between the first molded portion 16 and the second molded portion 18, and sealing properties between the two, are issues. Accordingly, in a resin molded product 10 according to the present embodiment (see FIG. 5), the first face 31 is annular, the second face 32 is a face that includes a normal of the first face 31, the second face 32 is annular and extends along the first face 31, the second face 32 is disposed adjacent to the first face 31, the third face 33 is recessed in a normal direction of the first face 31, the third face 33 is annular and extends along the first face 31, the third face 33 is disposed adjacent to the first face 31, on an opposite side from the second face 32, the fourth face 34 is recessed in a normal direction of the second face 32, the fourth face 34 is annular and extends along the second face 32, the fourth face 34 is disposed adjacent to the second face 32, on an opposite side from the first face 31, a distance on the first face 31 between the second face 32 and the third face 33 in the normal direction of the second face 32 is defined as a first distance L1, a distance on the second face 32 between the first face 31 and the fourth face 34 in the normal direction of the first face 31 is defined as a second distance L2, a distance on the third face 33 between the first face 31 and a position on the third face 33 farthest from the first face 31 in the normal direction of the first face 31 is defined as a third distance L3, a distance on the fourth face 34 between the second face 32 and a position on the fourth face 34 farthest from the second face 32 in the normal direction of the second face 32 is defined as a fourth distance L4, the fourth distance L4 has a relation as to the first distance L1 of $1/3 \leq$ the fourth distance L4 / the first distance L1 $\leq 9/10$, the third distance L3 has a relation as to the second distance L2 of $1/3 \leq$ the third distance L3 / the second distance L2 $\leq 9/10$, the first distance L1 has a relation as to the second distance L2 of $2/5 \leq$ the first distance L1 / the second distance L2 $\leq 5/2$.

As illustrated in FIG. 7 and FIG. 8, the first face 31 and the second face 32 are connected at the corner portion, the first face 31 and the third face 33 are connected at the corner portion, and the second face 32 and the fourth face 34 are connected at the corner portion. The second resin portion 19 covers all faces of the first face 31, the second face 32, the third face 33, and the fourth face 34.

The second resin portion 19 exhibits contraction during molding. The first resin portion 17 does not exhibit contraction, and accordingly the second resin portion 19 tensions the first face 31, the second face 32, the third face 33, and the fourth face 34, of the first resin portion 17. Referencing FIG. 8, arrows F1 and F2 indicate tensioning forces by which the second resin portion 19 tightens the first resin portion 17 due to contraction of the second resin portion 19 during molding. In the resin molded product 10 according to the present embodiment, the contraction of the second resin portion 19 enables the strength of the joint portion between the first resin portion 17 and the second resin portion 19, and the sealing properties therebetween, to be increased.

In the present embodiment, the first face 31, the second face 32, the third face 33, and the fourth face 34, are made up of the first plane 31, the second plane 72, the third plane 73, the fourth plane 74, the fifth plane 75, the sixth plane 76, the seventh plane 77, the eighth plane 78, the ninth plane 79, and the tenth plane 80. Among these planes, any plane is orthogonal to any other plane adjacent thereto.

Accordingly, when the first molded portion 16 is manufactured by injection molding, the combination of the molds does not need to be complicated, and the first molded portion 16 tends to not require forcible removal from the mold, but rather can be easily removed from the mold.

[Specific Configuration of Joint Portions]

The cross-section illustrated in FIG. 8 illustrates the first distance L1, the second distance L2, the third distance L3, and the fourth distance L4, according to the present embodiment. As described above, the mutual relation among the first distance L1, the second distance L2, the third distance L3, and the fourth distance L4 satisfies all of the following Expressions (1), (2), and (3).

$$\text{Expression (1): } 1/3 \leq \text{fourth distance L4 / first distance L1} \leq 9/10$$

$$\text{Expression (2): } 1/3 \leq \text{third distance L3 / second distance L2} \leq 9/10$$

$$\text{Expression (3): } 2/5 \leq \text{first distance L1 / second distance L2} \leq 5/2$$

According to "$1/3 \leq$ fourth distance L4 / first distance L1" in the above Expression (1), depth of the fourth face 34 in the Z direction is no smaller than 1/3 of the first distance L1. Depth in the Z direction of the second resin portion 19 that comes into contact with the fourth face 34 is thus sufficient, and the tension force (arrow F1 in FIG. 8) caused by the contraction of the second resin portion 19 is effectively transmitted to the fourth face 34. The seal formed between the first resin portion 17 and the second resin portion 19 has good sealing properties, and moisture does not readily intrude into gaps between the first resin portion 17 and the second resin portion 19 from external space.

According to "$1/3 \leq$ third distance L3 / second distance L2" in the above Expression (2), depth of the third face 33 in the X direction is no smaller than 1/3 of the second distance L2. Depth in the X direction of the second resin portion 19 that comes into contact with the third face 33 is thus sufficient, and the tension force (arrow F2 in FIG. 8) caused by the contraction of the second resin portion 19 is effectively transmitted to the third face 33. The seal formed between the first resin portion 17 and the second resin portion 19 has good sealing properties, and moisture does not readily intrude into gaps between the first resin portion 17 and the second resin portion 19 from external space.

According to "fourth distance L4 / first distance L1 $\leq 9/10$" in the above Expression (1) and "third distance L3 / second distance L2 $\leq 9/10$" in the above Expression (2), the position P1 and the position P2 are not excessively close to each other. That is to say, in a case in which the first molded portion 16 is considered as being a single unit, a corner block portion 54 of the first resin portion 17, which has the first face 31, the second face 32, the third face 33, and the fourth face 34, is prevented from being cut off from a main block part 53 that is the rest. The first molded portion 16 does not readily come off from the second molded portion 18.

According to the above Expression (3), one of the first distance L1 and the second distance L2 is not extremely great as compared to the other. With respect to one of the first distance L1 and the second distance L2, in a case in which the distance of the first distance L1 relative to the third distance L3 is extremely small or the distance of the second distance L2 relative to the fourth distance L4 is extremely small, the second resin portion 19 does not strongly tension the third face 33 or the fourth face 34, and accordingly improving the sealing properties of the seal formed between the first resin portion 17 and the second resin portion 19 is difficult.

[Other Matters]

In the above embodiment, the first face 31, the second face 32, the third face 33, and the fourth face 34 are each a plane or a combination of planes, and are faces that are mutually orthogonal. On the other hand, the first face 31, the second face 32, the third face 33, and the fourth face 34 of the present invention may each have shapes in which the faces are partially convex or recessed, as long as forcible removal is not necessary, or the first resin portion 17 is not plastically deformed, when the mold is removed. Also, for example, the first face 31 and the second face 32 are orthogonal to each other, but may intersect at another angle as long as forcible removal is not necessary. Similarly, for the other faces as well, the angles between adjacent faces do not have to be right angles.

The above-described embodiment is illustrative in all respects and is not restrictive. The scope of the present invention is defined by the claims rather than by the above-described embodiment, and includes all modifications within the scope equivalent to the configurations described in the claims.

Description of the Reference Numerals

| | |
|---|---|
| 7a, 7b | Mold |
| 10 | Resin molded product |
| 11 | Connector terminal (component) |
| 16 | First molded portion |
| 17 | First resin portion |
| 17a | Peripheral edge portion |
| 18 | Second molded portion |
| 19a | Molten resin |
| 19 | Second resin portion |
| 31 | First face |
| 32 | Second face |
| 33 | Third face |
| 34 | Fourth face |
| L1 | First distance |
| L2 | Second distance |
| L3 | Third distance |
| L4 | Fourth distance |

**Claims**

1. A resin molded product, comprising a first molded portion and a second molded portion, wherein

the first molded portion has a component as an insert, and a first resin portion that is integral with the component,
the second molded portion has a second resin portion,
the first resin portion has a first face, a second face, a third face, and a fourth face,
the first face is annular,
the second face is a face that includes a normal of the first face,
the second face is annular and extends along the first face,
the second face is disposed adjacent to the first face,
the third face is recessed in a normal direction of the first face,
the third face is annular and extends along the first face,
the third face is disposed adjacent to the first face, on an opposite side from the second face,
the fourth face is recessed in a normal direction of the second face,
the fourth face is annular and extends along the second face,
the fourth face is disposed adjacent to the second face, on an opposite side from the first face,
a distance on the first face between the second face and the third face in the normal direction of the second face is defined as a first distance,
a distance on the second face between the first face and the fourth face in the normal direction of the first face is defined as a second distance,
a distance on the third face between the first face and a position on the third face farthest from the first face in the normal direction of the first face is defined as a third distance,
a distance on the fourth face between the second face and a position on the fourth face farthest from the second face in the normal direction of the second face is defined as a fourth distance,
the fourth distance has a relation as to the first distance of $1/3 \leq$ the fourth distance / the first distance $\leq 9/10$,
the third distance has a relation as to the second distance of $1/3 \leq$ the third distance / the second distance $\leq 9/10$,
the first distance has a relation as to the second distance of $2/5 \leq$ the first distance / the second distance $\leq 5/2$, and
the second resin portion is in contact with all faces of the first face, the second face, the third face, and the fourth face, of the first resin portion.

2. A manufacturing method of the resin molded product according to claim 1, the manufacturing method comprising:

a preparation process of placing the first molded portion in a mold;

a molding process of supplying molten resin to the mold and molding the second molded portion; and
a demolding process of removing, from the mold, the resin molded product in which the first molded portion and the second molded portion have become integral when the molten resin is solidified.

# FIG. 1

# FIG. 2

# FIG. 3

EP 4 563 319 A1

FIG. 4

EP 4 563 319 A1

FIG. 5

EP 4 563 319 A1

# FIG. 6

# FIG. 7

FIG. 8

## INTERNATIONAL SEARCH REPORT

| International application No. |
|---|
| **PCT/JP2022/029111** |

### A. CLASSIFICATION OF SUBJECT MATTER

**B29C 45/14**(2006.01)i
FI: B29C45/14

According to International Patent Classification (IPC) or to both national classification and IPC

### B. FIELDS SEARCHED

Minimum documentation searched (classification system followed by classification symbols)

B29C45/14

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| Y | JP 2009-166368 A (DENSO CORP) 30 July 2009 (2009-07-30)<br>fig. 1-7 | 1-2 |
| Y | JP 2016-82129 A (DENSO CORP) 16 May 2016 (2016-05-16)<br>fig. 1-2, 7-12 | 1-2 |
| Y | JP 2021-37634 A (YAZAKI CORP) 11 March 2021 (2021-03-11)<br>fig. 2-7 | 1-2 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **31 August 2022** | **13 September 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

International application No.

**PCT/JP2022/029111**

| Patent document cited in search report | | | Publication date (day/month/year) | Patent family member(s) | | | Publication date (day/month/year) |
|---|---|---|---|---|---|---|---|
| JP | 2009-166368 | A | 30 July 2009 | (Family: none) | | | |
| JP | 2016-82129 | A | 16 May 2016 | US | 2016/0336199 | A1 | |
| | | | | fig. 11-12, 17-22 | | | |
| | | | | WO | 2015/129237 | A1 | |
| | | | | CN | 106030770 | A | |
| JP | 2021-37634 | A | 11 March 2021 | (Family: none) | | | |

Form PCT/ISA/210 (patent family annex) (January 2015)

**REFERENCES CITED IN THE DESCRIPTION**

**Patent documents cited in the description**

- JP 2022051061 A